# EUROPÄISCHE PATENTSCHRIFT

(11) **EP 2 110 949 B1**
(45) Veröffentlichungstag und Bekanntmachung des Hinweises auf die Patenterteilung: **24.07.2013**
(21) Anmeldenummer: 09005358.8
(22) Anmeldetag: 15.04.2009
(51) Int. Cl.: H03K 17/97, G01D 5/251, F16K 37/00, G01D 5/14

(54) **Sensoranordnung zur Erfassung von wenigstens zwei Winkelpositionen einer um eine Rotationsachse rotierenden Anordnung**
Sensor assembly for recording at least two angle positions of an assembly rotating around a rotation axis
Agencement de capteur destiné à déterminer au moins deux positions d'angle d'un agencement tournant autour d'un axe de rotation

(30) Priorität: 18.04.2008 DE 202008005466 U
(43) Veröffentlichungstag der Anmeldung: 21.10.2009
(73) Patentinhaber: FESTO AG & Co. KG, 73734 Esslingen (DE)
(72) Erfinder: Kießling, Albert, 71263 Weil der Stadt (DE); Dengler, Birgit, 73230 Kirchheim/Teck (DE); Geywitz, Volker, 73760 Ostfildern (DE)
(74) Vertreter: Kocher, Mark Werner

(56) Entgegenhaltungen:
- EP-A1- 0 439 037
- EP-A2- 0 735 347
- DE-C1- 19 546 240
- JP-A- 58 187 818

## Beschreibung

Die Erfindung betrifft eine Sensoranordnung zur Erfassung von wenigstens zwei Winkelpositionen einer um eine Rotationsachse rotierenden Anordnung, beispielsweise der Rotationsachse eines Ventilglieds eines Prozessventils, wie es in der EP 0439037 A1 beschrieben ist. Bei der bekannten Anordnung sind ein oder zwei Reed-Schalter beziehungsweise Reed-Relais an einer einen Permanentmagneten tragenden Welle angeordnet. Bei der bekannten Anordnung ist es problematisch, die Reed-Schalter variabel zu positionieren, insbesondere auch dann, wenn noch mehr als zwei Schalter positioniert werden sollen. Eine nachträgliche Justierung ist mit vernünftigem Aufwand kaum möglich.

Aus der EP 0 735 347 B1 ist eine Drehstellungsmessvorrichtung bekannt, die an einem Dreh-Stellglied befestigt ist, das einen umlaufenden Motor.in einem Gehäuse und eine davon wegragende Welle umfaßt, wobei ein Schwenkelement an der Welle befestigt und drehbeweglich ist, wobei das Schwenkelement durch mindestens einen Positionssensor detektierbar ist der verstellbar an dem Gehäuse befestigbar ist, und mit einem Nabenabschnitt, der fest und koaxial zur Welle mit dem Gehäuse verbunden ist, sowie mindestens einem Sensorhalter, der auf dem Nabenabschnitt drehbar angebracht und durch verrastendes Zusammenwirken zwischen einer elastischen Eingriffseinrichtung an dem Sensorhalter und einer gerasterten Oberfläche in ausgewählten Winkelpositionen fixierbar ist.

Eine Aufgabe der vorliegenden Erfindung besteht darin, eine Sensoranordnung zur Erfassung von wenigstens zwei Winkelpositionen einer um eine Rotationsachse rotierenden Anordnung zu schaffen, bei der zwei oder noch mehr magnetfeldsensitive Schalter in einfacher Weise auch noch nachträglich unabhängig voneinander positioniert werden können.

Diese Aufgabe wird erfindungsgemäß durch eine Sensoranordnung mit den Merkmalen des Anspruchs 1 gelöst. Durch die an den Halterungen angeordneten Schalter können diese mit Hilfe der Halterungen unabhängig voneinander justiert werden. Da die Schalter und somit auch deren Halterungen unterschiedlich axial und/oder radial zur Kreisbahn des Permanentmagneten versetzt angeordnet sind, können sie frei und unabhängig voneinander positioniert werden und auch zur Justierung aneinander vorbeigeschoben werden, da sie durch die unterschiedliche Anordnung nicht miteinander kollidieren. Weiterhin können die Schalter, bedingt durch die Halterungen, radial von der Rotationsachse entfernt angeordnet werden, so dass eine feinere Winkelauflösung erreicht werden kann.

Die Halterungen weisen jeweils ein die Welle umgreifendes Ringelement und ein sich von diesem Ringelement aus radial erstreckendes lineares oder L-förmiges Trägerelement für den jeweiligen Schalter auf.

Nach erfolgter Justierung werden die Halterungen mittels wenigstens eines Fixierelements in den justierten Positionen fixiert. Hierzu sind schwenkbar an der Welle angeordnete Klemmelemente zum Fixieren, insbesondere zum Zusammenklemmen, der Halterungen mittels einer Schraube ausgebildet, die an einer relativ zur Welle ortsfesten Stelle fixierbar sind, beispielsweise an einem Gehäuse der Sensoranordnung.

Durch die in den Unteransprüchen aufgeführten Maßnahmen sind vorteilhafte Weiterbildungen und Verbesserungen der im Anspruch angegebenen Sensoranordnung möglich.

Die Halterungen sind zur Justierung um eine gemeinsame Achse mit der Welle schwenkbar gelagert, insbesondere schwenkbar an der Welle gelagert, so dass ihr radialer Abstand bei der Justierung immer gleich bleibt und entsprechend dem radialen Abstand des Permanentmagneten von der Welle gewählt werden kann.

Der Permanentmagnet ist zweckmäßigerweise ebenfalls mittels einer Magnethalterung beabstandet von der Welle an dieser befestigt, damit er einen Schwenkradius erhält, der dem der Schalter im Wesentlichen entspricht.

Damit beim Fixieren der Halterungen für die Schalter in den Justierpositionen die Schwenkbarkeit der Magnethalterung und damit des Magneten erhalten bleibt, ist diese Magnethalterung zwischen zwei aneinander klemmbaren und dabei einen die Schwenkbewegung der Magnethalterung gewährleistenden Abstand einhaltenden Begrenzungselementen angeordnet, die ihrerseits schwenkbar an der Welle gelagert sind. Diese Begrenzungselemente können zusammen mit den Halterungen aneinander fixiert, insbesondere aneinander zusammengeklemmt werden. Die Magnethalterung weist vorteilhafterweise ein oder zwei Mitnehmerelemente zur Justierung von einer oder zwei Schalter tragenden Halterungen in einer oder beiden Winkelendlagen auf. Hierdurch können die Halterungen beziehungsweise deren Schalter durch eine einfache Bewegung der Welle in die beiden Endlagen automatisch positioniert werden.

Die Welle erstreckt sich zweckmäßigerweise durch ein Sensorgehäuse oder ragt in dieses hinein, wobei das Gehäuse einen von einem Basisteil abnehmbaren Deckel besitzt und die an den Halterungen angeordneten Schalter in ihren justierten Positionen am Basisteil fixierbar sind.

Das Basisteil enthält bevorzugt eine Platine, die eine elektrische Anschlussanordnung für die Schalter trägt.

Als magnetfeldempfindliche Schalter eignen sich vorzugsweise Reed-Schalter oder Hall-Schalter.

Ein Ausführungsbeispiel der Erfindung ist in der Zeichnung dargestellt und in der nachfolgenden Beschreibung näher erläutert. Es zeigen:
- Figur 1: eine perspektivische Explosionsdarstellung einer mit einem Sensorgehäuse versehenen Sensoranordnung mit drei magnetfeldempfindlichen Schaltern als Ausführungsbeispiel der Erfindung und
- Figur 2: eine Draufsicht auf die in Figur 1 dargestellte Sensoranordnung bei abgenommenem Deckel des Sensorgehäuses.

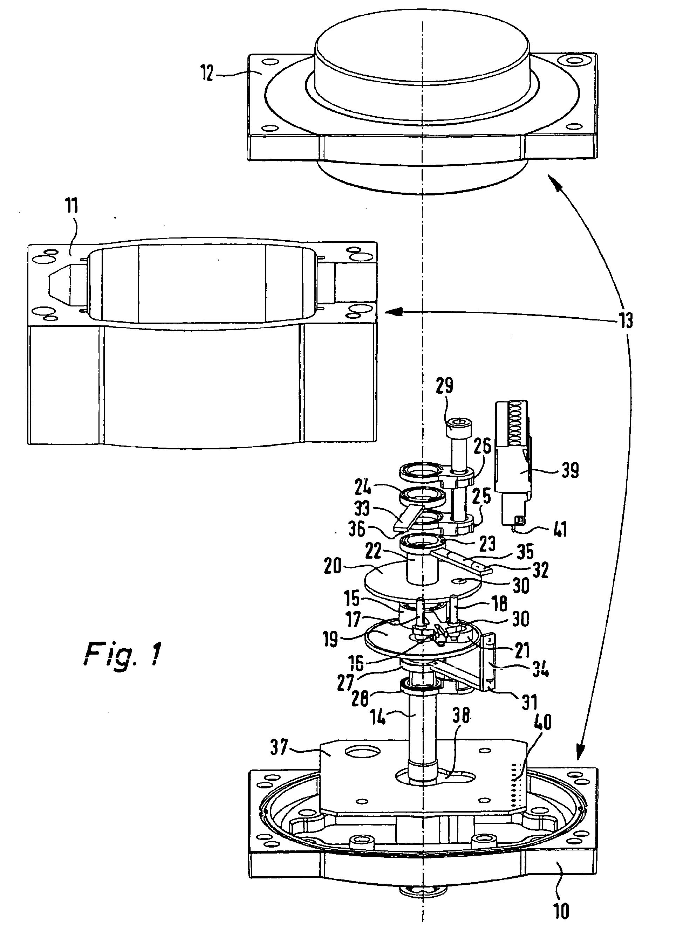

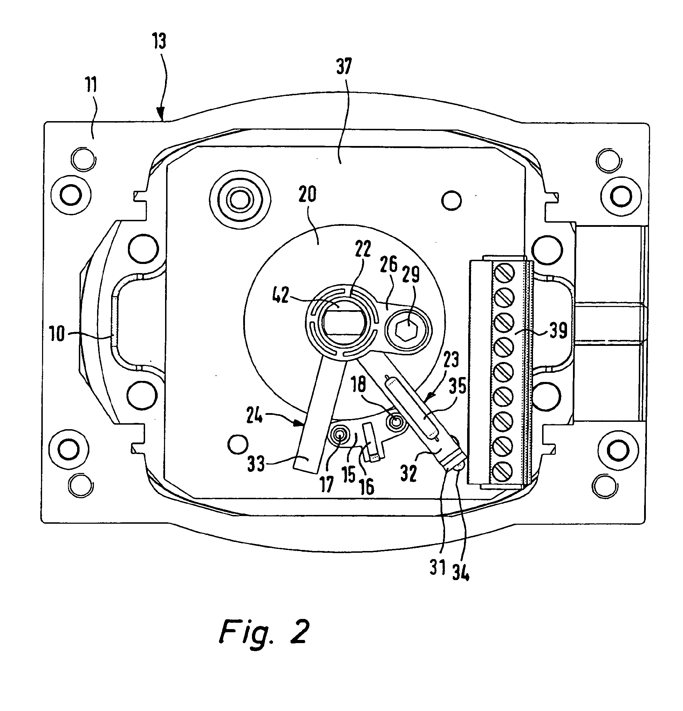

Bei dem in den Figuren 1 und 2 dargestellten Ausführungsbeispiel für eine Sensoranordnung enthält ein aus einem Basisteil 10, einem Zwischenteil 11 und einem Deckel 12 bestehendes Sensorgehäuse 13 eine Welle 14, die an der Unterseite des Basisteils 10 herausragt und mit einer nicht dargestellten rotierenden Anordnung gekoppelt werden kann, deren Drehwinkel beziehungsweise deren Winkelstellung gemessen werden soll. Bei einer solchen rotierenden Anordnung kann es sich beispielsweise um die mit einem Ventilglied eines Prozessventils verbundene Welle handeln. Die Kopplung zwischen der rotierenden Anordnung und der Welle 14 kann in an sich bekannter Weise durch Zusammenstecken, Verschrauben, Verklemmen oder dergleichen erfolgen.

Eine Magnethalterung 15 besteht aus einem die Welle 14 umgreifenden und mit dieser drehfest verbundenen Ringelement, von dem aus sich in radialer Richtung ein lineares Trägerelement erstreckt, das einen axial magnetisierten Permanentmagneten 16 trägt.

Die Magnethalterung 15 kann durch geeignete konstruktive Maßnahmen, z.B. über eine Rutschkupplung oder Klemmeinrichtung, mit der Welle 14 verbunden sein, so dass diese zwar drehfest miteinander verbunden sind, die Magnethalterung 15 aber dennoch bei dafür ausreichendem Kraftaufwand auch in eine andere Position gedreht werden kann. Durch eine solche oder ähnliche Maßnahme bleibt die Magnethalterung 15 auch nach dem Verdrehen drehfest mit der Welle 14 verbunden.

Zu beiden Seiten des Permanentmagneten 16 erstrecken sich parallel zur Welle 14 zwei Mitnehmerstifte 17, 18 in Figur 1 nach oben, also in Richtung zum freien Endbereich der Welle 14 im Sensorgehäuse 13. Auf die Funktion dieser Mitnehmerstifte 17, 18 wird später noch näher eingegangen.

Zwei kreisscheibenförmige Begrenzungselemente 19, 20 sind zu beiden Seiten der Magnethalterung 15 schwenkbar an der Welle 14 gelagert. Ein ringscheibenförmiges Abstandselement 21 am unteren Begrenzungselement 19 ist dem oberen Begrenzungselement 20 zugewandt und dient dazu, einen Minimalabstand zwischen den Begrenzungselementen 19, 20 einzuhalten, der noch die freie Drehbarkeit der Magnethalterung 15 dazwischen gestattet. Anstelle eines Abstandselements 21 am unteren Begrenzungselement 19 kann zusätzlich noch ein solches Abstandselement am oberen Begrenzungselement 20 angeordnet sein, wobei dann die beiden Abstandselemente zusammen den Minimalabstand gewährleisten.

Vom oberen Begrenzungselement 20 aus erstreckt sich konzentrisch ein rohrartiger Fortsatz 22 nach oben, der fest mit dem Begrenzungselement 20 verbunden ist, beispielsweise einstückig verbunden, und somit ebenfalls schwenkbar an der Welle 14 gelagert ist. Auf diesem rohrartigen Fortsatz 22 sind zwei Sensorhalterungen 23, 24 sowie zwei Klemmelemente 25, 26 schwenkbar gelagert.

Entsprechend erstreckt sich vom unteren Begrenzungselement 19 aus ein fest mit diesem verbundener rohrartiger Fortsatz nach unten, der jedoch in der Zeichnung aufgrund der perspektivischen Darstellung nicht erkennbar ist. Auf diesem rohrartigen Fortsatz sind ähnlich dem oberen rohrartigen Fortsatz 22 eine Sensorhalterung 27 und ein Klemmelement 28 schwenkbar gelagert.

Die Klemmelemente 25, 26, 28 bestehen jeweils aus einem Ringelement mit angeformter Schraubenöse zum Durchstecken einer Halteschraube 29. In gleichem radialem Abstand weisen die Begrenzungselemente 19, 20 beziehungsweise das darauf angeordnete Abstandselement 21 Durchstecklöcher 30 zum Durchstecken der Halteschraube 29 auf.

Oberhalb des oberen Begrenzungselements 20 ist die obere Sensorhalterung 24 zwischen den beiden Klemmelementen 25, 26 angeordnet, während die untere Sensorhalterung 23 zwischen dem Klemmelement 25 und dem Begrenzungselement 20 angeordnet ist. Unterhalb des unteren Begrenzungselements 19 ist die Sensorhalterung 27 zwischen dem Begrenzungselement 19 und dem Klemmelement 28 angeordnet.

Die Sensorhalterungen 23, 24, 27 weisen jeweils ein Ringelement ähnlich dem Ringelement der Klemmelemente 25, 26, 28 auf, das schwenkbar am oberen rohrartigen Fortsatz 22 des oberen Begrenzungselements 20 beziehungsweise am unteren, nicht dargestellten rohrartigen Fortsatz des unteren Begrenzungselements 19 schwenkbar gelagert ist. Es ist jedoch alternativ auch möglich, die Sensorhalterungen 23, 24, 27 direkt an der Welle 14 schwenkbar zu lagern. Von den Ringelementen der Sensorhalterungen 23, 24, 27 aus erstrecken sich Trägerelemente 31-33 zur Aufnahme von magnetfeld-sensitiven Schaltern 34-36 radial nach außen, wobei das Trägerelement 31 der untersten Sensorhalterung 27 L-förmig ausgebildet ist und der Schalter 34 am parallel zur Welle 14 verlaufenden Schenkel des Trägerelements 31 angebracht ist. Die beiden Trägerelemente 32, 33 der beiden oberen Sensorhalterungen 23, 24 sind in Form eines linearen Plättchens ausgebildet und tragen die entsprechend radial nach außen orientierten Schalter 35, 36.

Die magnetfeld-sensitiven Schalter 34-36 sind beispielsweise als Reed-Schalter beziehungsweise Reed-Relais oder Hall-Schalter ausgebildet, wobei auch andere magnetfeld-sensitive Schalter möglich sind.

Durch die Anordnung in unterschiedlichen Ebenen können die Sensorhalterungen 23, 24, 27 unabhängig voneinander in die gewünschten Sensorpositionen geschwenkt werden. Der abgewinkelte Schenkel des unteren Trägerelements 31 ist dabei so weit radial von der Welle 14 entfernt, dass sich die Trägerelemente 32, 33 der beiden anderen Sensorhalterungen 23, 24 vorbeibewegen können. Sind die Sensorhalterungen 23, 24, 27 beziehungsweise die darauf gehaltenen Schalter 34-36 in der gewünschten Winkelstellung justiert, so können die Sensorhalterungen 23, 24, 27 mit Hilfe der Klemmelemente 25, 26, 28 und der Begrenzungselemente 19, 20 miteinander verklemmt werden, indem die Halteschraube 29 mit dem Basisteil 10 verschraubt wird und dadurch die genannten Elemente zusammenklemmt. Lediglich die Magnethalterung 15 bleibt infolge des Abstandselements 21 frei schwenkbar zusammen mit der Welle 14.

Durch die Mitnehmerstifte 17, 18 ist eine automatische Positionierung der beiden oberen Sensorhalterungen 23, 24 in den beiden Endpositionen beziehungsweise Winkelendstellungen möglich. Die Trägerelemente 32, 33 sind zu Beginn dieser Positionierbewegung zu beiden Seiten der Mitnehmerstifte 17, 18 angeordnet. Durch eine Schwenkbewegung der Welle 14 zuerst in die eine und dann in die andere Endposition verschieben die Mitnehmerstifte 17, 18 die beiden Sensorhalterungen 23, 24 in diese beiden Endstellungen. Die untere Sensorhalterung 27 kann in eine beliebige Zwischenposition gebracht werden.

Selbstverständlich können in Erweiterung der dargestellten Anordnung noch weitere Sensorhalterungen mit weiteren Schaltern an der Welle 14 beziehungsweise den rohrartigen Fortsätzen 22 schwenkbar gelagert und zusammen mit den beschriebenen Elementen in der justierten Position verklemmt und dadurch fixiert werden. Weiterhin können die Schalter 34-36 wahlweise radial gemäß den Schaltern 35, 36 oder axial gemäß dem Schalter 34 angeordnet werden, wobei dann die Sensorhalterungen entsprechend den Sensorhalterungen 23, 24 oder der Sensorhalterung 27 ausgebildet sein müssen.

Im Basisteil 10 ist eine als Leiterplatte ausgebildete Platine 37 angeordnet. Sie besitzt eine zentrale Durchgangsöffnung 38, durch die sich die Welle 14 hindurch erstreckt. Diese zentrale Durchgangsöffnung 38 hat eine Kontur, die der eines Klemmelements entspricht, so dass das unterste Klemmelement 28 in diese zentrale Durchgangsöffnung 38 eingreifen kann, wodurch es direkt am Basisteil 10 fixiert werden kann, wenn die Halteschraube 29 alle beschriebenen Elemente miteinander verklemmt.

Die Platine 37 trägt eine elektrische Anschlussanordnung 39, die über Leitungen und/oder Leiterbahnen mit den Schaltern 34-36 verbunden ist. Dadurch kann ein nicht dargestelltes Kabel zur Verbindung der Schalter 34-36 mit einer nicht dargestellten Steuervorrichtung, beispielsweise zur Steuerung eines Prozessventils, das mit der Welle 14 verbunden ist, an diese Anschlussanordnung 39 angeschlossen werden. In der Explosionsdarstellung gemäß Figur 1 sind in der Platine 37 Aufnahmelöcher 40 für entsprechende Kontaktstifte 41 der elektrischen Anschlussanordnung 39 dargestellt.

Der Permanentmagnet 16 kann als Stabmagnet oder Ringausschnittmagnet ausgebildet sein. Seine ihn tragende Magnethalterung 15 kann bei einer einfacheren Ausführung auch ohne Mitnehmerstifte 17, 18 ausgebildet sein.

Infolge der Halteschraube 29 ist die Schwenkbarkeit der Sensorhalterungen 23, 24, 27 auf einen Winkel von weniger als 360° begrenzt, beispielsweise auf einen Winkel von 300°.

Durch entsprechende konstruktive Maßnahmen, z.B. Versetzen der Halteschraube 29 nach außen, kann auch erreicht werden, dass die Sensorhalterungen 23, 24, 27 bzw. deren Trägerelemente 31 bis 33 um 360° schwenkbar werden.

Bei verschraubtem Gehäuse kann die beschriebene Sensoranordnung als kompakte Einheit auf einer Welle oder an einer rotierenden Anordnung montiert werden, bei der verschiedene Winkelpositionen erfaßt werden sollen.

Die Welle 14 besitzt an ihrem freien oberen Endbereich ein Anzeigeelement 42, das durch Einformungen in der Welle 14 gebildet ist, und das die Winkelstellung der Welle 14 optisch kennzeichnet. Alternativ hierzu kann auch ein solches Anzeigeelement am freien Ende der Welle 14 aufgesteckt oder auf sonstige Weise befestigt sein. Der Deckel 12 des Sensorgehäuses 13 ist entweder durchsichtig ausgebildet oder besitzt ein Fenster, durch das das Anzeigeelement 18 beobachtet werden kann.

Die Schalter 34-36 können noch mit einer visuellen Anzeige versehen sein, beispielsweise jeweils mit einer zusätzlichen LED, um das Schalten dieser Schalter 34-36 jeweils im Bereich des Magnetfeldes optisch zu kennzeichnen. Diese visuelle Anzeige kann selbstverständlich auch außen am Gehäuse angeordnet sein, falls der Deckel 12 keine direkte Beobachtung der Schalter 34-36 beziehungsweise der entsprechenden Sensorhalterungen 23, 24, 27 möglich macht.

## Patentansprüche

1. Sensoranordnung zur Erfassung von wenigstens zwei Winkelpositionen einer um eine Rotationsachse rotierenden Anordnung, mit einer mit der rotierenden Anordnung gekoppelten oder koppelbaren Welle (14), die mit einem Permanentmagneten (16) drehfest verbunden ist, und mit wenigstens zwei durch das Magnetfeld des sich jeweils vorbeibewegenden oder sich nähernden Permanentmagneten (16) auslösbaren magnetfeldsensitiven Schaltern (34-36), die an Halterungen (23, 24, 27) angeordnet sind, welche unabhängig voneinander in unterschiedlichen Winkelpositionen justierbar sind, wobei die Halterungen (23, 24, 27) jeweils ein die Welle (14) umgreifendes Ringelement und ein sich von diesem Ringelement aus radial erstreckendes lineares oder L-förmiges Trägerelement (31-33) für den jeweiligen Schalter (34-36) aufweisen und mittels wenigstens eines Fixierelements (29) in den justierten Positionen fixierbar sind, **dadurch gekennzeichnet, dass** die Schalter (34-36) zur Kreisbahn des Permanentmagneten (16) um die Welle (14) unterschiedlich axial und/oder radial versetzt angeordnet sind und dass schwenkbar an der Welle (14) angeordnete Klemmelemente (25, 26, 28) zum Fixieren der Halterungen (23, 24, 27) mittels des als Schraube ausgebildeten Fixierelements (29) ausgebildet sind.

2. Sensoranordnung nach Anspruch 1, **dadurch gekennzeichnet, dass** die Halterungen (23, 24, 27) zur Justierung um eine gemeinsame Achse mit der Welle (14) schwenkbar gelagert sind, insbesondere schwenkbar an der Welle (14) gelagert sind.

3. Sensoranordnung nach Anspruch 1, **dadurch gekennzeichnet, dass** sie ein Gehäuse (13) aufweist, an dem das Fixierelement (29) fixierbar ist.

4. Sensoranordnung nach einem der vorhergehenden Ansprüche, **dadurch gekennzeichnet, dass** der Permanentmagnet (16) mittels einer Magnethalterung (15) beabstandet von der Welle (14) an dieser befestigt ist.

5. Sensoranordnung nach Anspruch 4, **dadurch gekennzeichnet, dass** die Magnethalterung (15) zwischen zwei aneinander klemmbaren und dabei einen die Schwenkbewegung der Magnethalterung (15) gewährleistenden Abstand einhaltenden Begrenzungselementen (19, 20) angeordnet ist, die ihrerseits schwenkbar an der Welle (14) gelagert sind.

6. Sensoranordnung nach Anspruch 5, **dadurch gekennzeichnet, dass** die Begrenzungselemente (19, 20) zusammen mit den Halterungen (23, 24, 27) aneinander fixierbar, insbesondere aneinander zusammenklemmbar ausgebildet sind.

7. Sensoranordnung nach einem der Ansprüche 4 bis 6, **dadurch gekennzeichnet, dass** die Magnethalterung (15) ein oder zwei Mitnehmerelemente (17, 18) zur Justierung von einer oder zwei Schalter (32, 33) tragenden Halterungen (23, 24) in einer oder beiden Winkelendlagen aufweist.

8. Sensoranordnung nach einem der vorhergehenden Ansprüche, **dadurch gekennzeichnet, dass** die Welle (14) durch ein Sensorgehäuse (13, 14) verläuft oder in dieses hineinragt.

9. Sensoranordnung nach Anspruch 8, **dadurch gekennzeichnet, dass** das Gehäuse einen von einem Basisteil (10) abnehmbaren Deckel (12) besitzt, wobei die an den Halterungen (23, 24, 27) angeordneten Schalter (34-36) in ihrer justierten Position mittels des Fixierelements (29) am Basisteil (10) fixierbar sind.

10. Sensoranordnung nach Anspruch 8 oder 9, **dadurch gekennzeichnet, dass** das Basisteil (10) eine Platine (37) enthält, die eine elektrische Anschlussanordnung (39) für die Schalter (34-36) trägt.

11. Sensoranordnung nach einem der vorhergehenden Ansprüche, **dadurch gekennzeichnet, dass** die Schalter (34-36) als Reed-Schalter oder Hall-Schalter ausgebildet sind.

## Claims

1. Sensor arrangement for the detection of at least two angular positions of an arrangement rotating around a rotation axis, with a shaft (14) which is or may be coupled to the rotating arrangement and is connected non-rotatably to a permanent magnet (16), and with at least two magnetic-field-sensitive switches (34-36) able to be triggered by the magnetic field of the respective passing or approaching permanent magnet (16) and located on mounts (23, 24, 27) which can be adjusted independently of one another in different angular positions, wherein each of the mounts (23, 24, 27) has a ring element encompassing the shaft (14) and a linear or L-shaped support element (31-33) for the respective switch (34-36), extending radially from this ring element and able to be fixed in the adjusted positions by means of at least one locating element (29), **characterised in that** the switches (34-36) are arranged around the shaft (14) axially and/or radially offset to differing degrees from the circular path of the permanent magnet (16), and that clamping elements (25, 26, 28) mounted pivotably on the shaft (14) are designed for fixing the mounts (23, 24, 27) by means of the locating element (29) in the form of a screw.

2. Sensor arrangement according to claim 1, **characterised in that** the mounts (23, 24, 27) are supported for adjustment around a common axis with the shaft (14), in particular being mounted pivotably on the shaft (14).

3. Sensor arrangement according to claim 1, **characterised in that** it has a housing (13) to which the locating element (29) may be fixed.

4. Sensor arrangement according to any of the preceding claims, **characterised in that** the permanent magnet (16) is fastened to the shaft (14), with clearance from it, by a magnetic mount (15).

5. Sensor arrangement according to claim 4, **characterised in that** the magnetic mount (15) is arranged between two limiting elements (19, 20), which may be clamped to one another and at the same time maintain a clearance ensuring the pivoting movement of the magnetic mount (15), and which for their part are mounted pivotably on the shaft (14).

6. Sensor arrangement according to claim 5, **characterised in that** the limiting elements (19, 20) together with the mounts (23, 24, 27) are designed for fixing to one another, in particular for clamping together.

7. Sensor arrangement according to any of claims 4 to 6, **characterised in that** the magnetic mount (15) has one or two driver elements (17, 18) for the adjustment of mounts (23, 24) carrying one or two switches (32, 33) in one or both angular end positions.

8. Sensor arrangement according to any of the preceding claims, **characterised in that** the shaft (14) runs through or extends into a sensor housing (13, 14).

9. Sensor arrangement according to claim 8, **characterised in that** the housing has a cover (12) which may be removed from a base part (10), wherein the switches (34-36) located on the mounts (23, 24, 27) may be fixed in their adjusted positions to the base part (10) by means of the locating element (29).

10. Sensor arrangement according to claim 8 or 9, **characterised in that** the base part (10) contains a printed circuit board (37) which carries an electrical connection arrangement (39) for the switches (34-36).

11. Sensor arrangement according to any of the preceding claims, **characterised in that** the switches (34-36) are in the form of reed switches or Hall switches.

## Revendications

1. Ensemble de capteurs servant à détecter au moins deux positions d'angle d'un ensemble tournant autour d'un axe de rotation, comprenant un arbre (14) pouvant être couplé ou couplé à l'ensemble en rotation, lequel est relié de manière solidaire en rotation à un aimant permanent, et comprenant au moins deux commutateurs (34-36) sensibles au champ magnétique pouvant être déclenchés par le champ magnétique de l'aimant permanent (16) passant le long desdits commutateurs ou s'en approchant, lesquels commutateurs sont disposés au niveau de dispositifs de support (23, 24, 27), qui peuvent être ajustés indépendamment les uns des autres dans diverses positions d'angle, sachant que les dispositifs de support (23, 24, 27) présentent respectivement pour le commutateur (34-36) respectif un élément annulaire saisissant entourant l'arbre (14) et un élément de support (31 -33) en forme de L ou linéaire s'étendant radialement depuis ledit élément annulaire et qu'ils peuvent être fixés dans les positions ajustées au moyen au moins d'un élément de fixation (29), **caractérisé en ce que** les commutateurs (34-36) sont décalés de manière différente axialement et/ou radialement pour la trajectoire circulaire de l'aimant permanent (16) autour de l'arbre, et **en ce que** des éléments de serrage (25, 26, 28) disposés de manière à pouvoir pivoter au niveau de l'arbre (14) sont conformés pour fixer des dispositifs de support (23, 24, 27) au moyen de l'élément de fixation (29) se présentant sous la forme d'une vis.

2. Ensemble de capteurs selon la revendication 1, **caractérisé en ce que** les dispositifs de fixation (23, 24, 27) sont logés de manière à pouvoir pivoter autour d'un axe commun avec l'arbre (14) aux fins de l'ajustage, en particulier sont logés de manière à pouvoir pivoter au niveau de l'arbre (14).

3. Ensemble de capteurs selon la revendication 1, **caractérisé en ce qu'**il présente un boîtier (13), au niveau duquel l'élément de fixation (29) peut être fixé.

4. Ensemble de capteurs selon l'une quelconque des revendications précédentes, **caractérisé en ce que** l'aimant permanent (16) est fixé au niveau de l'arbre (14) à distance de ce dernier au moyen d'un dispositif de support à aimant (15).

5. Ensemble de capteurs selon la revendication 4, **caractérisé en ce que** le dispositif de support à aimant (15) est disposé entre deux éléments de délimitation (19, 20) pouvant être serrés l'un contre l'autre et ce faisant respectant une distance garantissant le mouvement de pivotement du dispositif de support à aimant (15), lesquels éléments de délimitation sont logés de leur côté de manière à pouvoir pivoter au niveau de l'arbre (14).

6. Ensemble de capteurs selon la revendication 5, **caractérisé en ce que** les éléments de délimitation (19, 20) peuvent être fixés conjointement avec les dispositifs de support (23, 24, 27), et sont réalisés en particulier de manière à pouvoir être serrés ensemble les uns contre les autres.

7. Ensemble de capteurs selon l'une quelconque des revendications 4 à 6, **caractérisé en ce que** le dispositif de support à aimant (15) présente un ou deux éléments d'entraînement (17, 18) servant à ajuster des dispositifs de support (23, 24) supportant un ou deux commutateurs (32, 33) dans une ou deux positions de fins de course d'angle.

8. Ensemble de capteurs selon l'une quelconque des revendications précédentes, **caractérisé en ce que** l'arbre (14) s'étend à travers un boîtier de capteurs (13, 14) ou fait saillie à l'intérieur de ce dernier.

9. Ensemble de capteurs selon la revendication 8, **caractérisé en ce que** le boîtier comprend un couvercle (12) pouvant être retiré d'une partie de base (10), sachant que les commutateurs (34 -36) disposés au niveau des dispositifs de support (23, 24, 27) peuvent être fixés au niveau de la partie de base (10) dans leur position ajustée au moyen de l'élément de fixation (29).

10. Ensemble de capteurs selon la revendication 8 ou 9, **caractérisé en ce que** la partie de base (10) contient une platine (37) qui supporte un ensemble de connexion électrique (39) pour les commutateurs (34 - 36).

11. Ensemble de capteurs selon l'une quelconque des revendications précédentes, **caractérisé en ce que** les commutateurs (34 - 36) se présentent sous la forme de commutateurs Reed ou de commutateurs Hall.
